Europäisches Patentamt

European Patent Office

Office européen des brevets

(11) Publication number: **0 317 770**
**A1**

# (12) EUROPEAN PATENT APPLICATION

(21) Application number: 88117649.9

(22) Date of filing: 24.10.88

(51) Int. Cl.⁴: **H01L 21/90 , H01L 21/31**

(30) Priority: 23.11.87 US 123754

(43) Date of publication of application:
**31.05.89 Bulletin 89/22**

(84) Designated Contracting States:
**DE FR GB IT**

(71) Applicant: **TEXAS INSTRUMENTS INCORPORATED**
**13500 North Central Expressway**
**Dallas Texas 75265(US)**

(72) Inventor: **McMann, Ronald E.**
**Route 1 Box 127W**
**Rosenberg Texas(US)**
Inventor: **Garcia, Evaristo, Jr.**
**725 Blume Apt. No. 111**
**Rosenberg Texas(US)**
Inventor: **Welch, Michael Thomas**
**1750 Jo Ann Lane**
**Sugarland Texas 77478(US)**

(74) Representative: **Leiser, Gottfried, Dipl.-Ing. et al**
**Patentanwälte Prinz, Leiser, Bunke & Partner**
**Manzingerweg 7**
**D-8000 München 60(DE)**

(54) **Self aligned planar metal interconnection for a VLSI device.**

(57) A method of interconnecting metal layers in integrated circuits separated by an intermediate dielectric layer by forming first (12,14) and pillar (16,18) layers of metal, etching the pillar layer to form a pillar of electrically conducting material and etching the first level (12,14) to form the first level lead having at least two sides vertically aligned with the pillar (16,18). A layer of dielectric (36) is applied to cover the pillar and first level lead. a layer of photoresist is deposited over the dielectric with a spin on technique to form a planar surface. The dielectric and photoresist are etched back with an equal etch rate until top portion of the pillar is exposed. A second level lead (42,44) is formed atop the pillar (16,18) and planar top surface of the dielectric.

FIG. 12

## SELF ALIGNED PLANAR METAL INTERCONNECTION FOR A VLSI DEVICE

### OTHER APPLICATIONS

The present application discloses subject matter to which copending application S.N. 676,132, filed on November 29, 1984 by Fuller and Morris is pertinent, and the present application is a continuation-in-part of S.N. 011,355 (Attorney Docket TI-11252A), filed January 19, 1987, a continuation of application S.N. 762,885, filed August 6, 1985 by McMann et al., now abandoned, all applications having been assigned to Texas Instruments.

### TECHNICAL FIELD OF THE INVENTION

The present invention relates to a method of forming self aligned planar interconnections between metal layers separated by a dielectric layer in a VLSI device.

### BACKGROUND OF THE INVENTION

The standard technique for interconnecting metal layers through an intermediate dielectric known as the "via process" has been to simply etch a hole defined by a layer of photoresist placed over the dielectric. The etch process used has been either the older wet etch process or a dry etch one. In the wet etch process, sloped, isotropically etched sidewalls result, while dry etching creates near-vertical oxide steps due to its anistropic etching behavior. Generally following dry etching and before metal deposition, the intermediate dielectric is heating until it reflows to slope the hole sidewall. This sloping helps to minimize thinning of a metal layer deposited over the walls of the hole. The latter metal deposition provides ohmic contact with the underlying metal layer through the etched hole.

While the via process has proven successful for LSI and early VLSI technology, the shrinking gap between contacts required in advanced VLSI technology has revealed major problems with the via process. The standard via process requires leads which are flared around the top of the via. This flaring requirement restricts the metal pitch and requires about 20% to 30% more bar area. A step coverage problem arises in via interconnections because of the reduced thickness of conductor laid down over the sidewall of the passageway when making the plug or interconnect conducting layer, thus causing excessive circuit resistance of the interconnect.

Due to the lack of planarity of the upper metal layer in the region of the interconnect resulting from the via process, a via interconnection cannot be laid down over another via interconnection or over a contact. A design limitation occurs when placing via formed interconnects adjacent to one another or adjacent leads. With extremely tight metal pitches, the slopes of the adjacent interconnects tend to run together and cause metal shorts. Numerous other potential problems occur due to lack of planarity in via formed interconnects when dealing with multilevel metal systems.

The above-noted copending applications disclose techniques for forming metal pillar interconnections extending through a dielectric layer between spaced apart metal layers. A need has however arisen for a technique for forming metal pillars with substantially vertical sides and which may be self aligned to the device lead structure.

It is therefore a technical advantage of the present invention in providing an improved method of self aligned interconnection between metal layers suitable for high density integrated circuits.

It is a further technical advantage by providing a method of self aligned interconnection which permits planarity of the upper metal layer in the region of the interconnection.

It is another technical advantage of this invention in providing a method of self aligned interconnection of metal layers which substantially increases the sidewall pitch of the interconnection and therefore permits closer spacing of adjacent interconnections.

### SUMMARY OF THE INVENTION

In accordance with the invention, there is provided a method of interconnecting different metal layers through an intermediate dielectric layer. The method includes forming first and pillar layers of electrically conducting material on the face of a semiconductor. The pillar layer is etched to form a pillar of conducting material while the first layer is etched to form aligned first level leads having the same dimensional configuration as the pillar leads, according to a self-aligning technique in accordance with the invention. A layer of dielectric is applied so as to cover both the pillar and the first level leads. A layer is deposited over the dielectric forming a planar surface thereover. The dielectric and photoresist are selected so their rate of etching is substantially in the ratio of 1:1. The photoresist and dielectric are then etched back leaving a small portion of the pillar exposed. A layer of conducting material is deposited over the pillar to form a second level lead.


## BRIEF DESCRIPTION OF THE DRAWINGS

The invention will be better understood by reference to the detailed description which follows, read in conjunction with the accompanying drawings, wherein:

FIGURE 1 is an elevation view in section of a semiconductor device with a series of alternating metal alloy layers of titanium tungsten alloy and aluminum copper alloy deposited thereon;

FIGURE 2 is an elevation view of the device of FIGURE I with the top layer etched to the dimensions of the pillar interconnections;

FIGURE 3 is a plan view of the device shown in FIGURE 2;

FIGURE 4 is an elevation view in section of the device shown in FIGURES 2 and 3 with a lead photoresist area defined;

FIGURE 5 is a top view of the device of FIGURE 4;

FIGURE 6 is an elevational view in section of the device of FIGURES 4 and 5 with the first lead defined and etched into the top layer of aluminum copper and underlying titanium-tungsten;

FIGURE 7 is a plan view of the device shown in FIGURE 6;

FIGURE 8 is an elevation view in section of the device with the first level lead, the pillar interconnection defined and the top pillar pad of titanium-tungsten removed;

FIGURE 9 is a plan view of the device shown in FIGURE 8;

FIGURE 10 is an elevation view in section of the device of FIGURES 8 and 9 with layers of plasma oxide and photoresist deposited thereon;

FIGURE 11 is an elevation view in section of the device of FIGURE 10 with the photoresist and plasma oxide etched back to expose the pillar interconnection; and

FIGURE 12 is the device of FIGURE 11 with a second level lead deposited onto the pillar interconnection.


## DETAILED DESCRIPTION WITH REFERENCE TO THE DRAWINGS

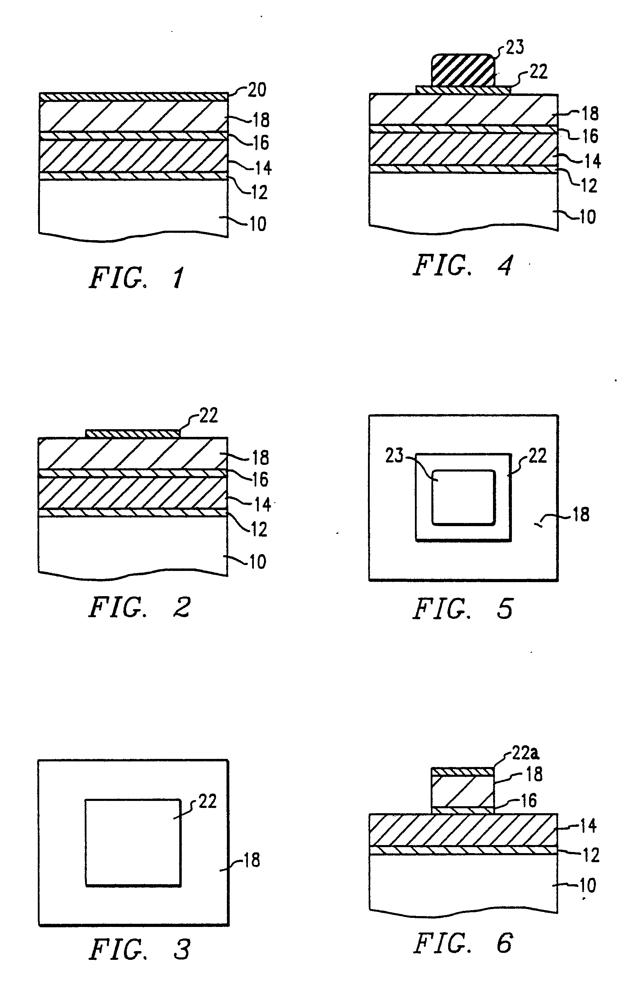

Referring to FIGURE 1, successive alternating layers of titanium-tungsten 12, 16, and 20 and aluminum-copper 14 and 18 alloys are deposited onto a semiconductor face 10 by a sputter system having multi-target capabilities. The thickness of each titanium tungsten (TiW) layer is about 2300 A, while that for each aluminum-copper layer is about 5,000 A.

A pillar mask cap area is defined using positive photoresist and the direct step on wafer (DSW) align and expose technique. The top layer of TiW is selectively etched in a Reactive Ion Etch System using dry Fluorine chemistry to form a pillar mask cap 22 in TiW layer 20 as shown in FIGURES 2 and 3. Undercutting of the TiW during the etching process is minimal so that the final dimensions of the pillar interconnection can be made to be less than the current limits of about 3 microns by 3 microns. After etch, the photoresist pad is removed in a wet resist strip which also acts as a protection against Al-Cu corrosion. The dimensions of the pillar mask cap 22 may vary, but will have an area slightly greater than the desired pillar configuration in order to provide the self-aligning aspect of the invention. In one embodiment, the area of the pillar mask cap 22 may be 2 microns in width by 3 microns in length in order to finally fabricate a pillar connection having dimensions of 2 microns by 2 microns and self aligned on two sides to a subsequent lead pattern. Alternatively, and as shown in the present drawings, the pillar mask cap may be slightly wider than 2 microns in order to self align the pillar connection on four sides.

FIGURES 4 and 5 illustrate the forming of a lead photoresist region 23. Photoresist region 23 is dimensioned to have the desired dimensions of the lead interconnection, such as 2 microns wide and unlimited length. The region 23 can also be dimensioned to form a lead pad, such as 2 microns wide by 2 microns long, which will serve to allow a second level interconnect to make direct contact to substrate 10.

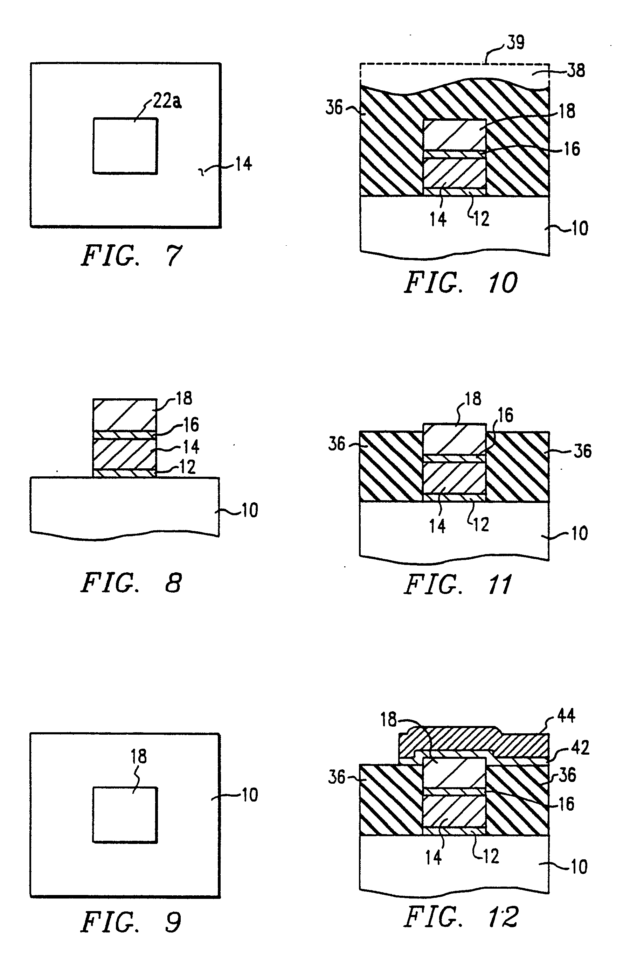

The first level lead pattern 23 is necessarily positioned and dimensioned so that the non-self aligned sides of the pillar mask cap 22 are within and bounded by the confines of the former. However, the sides of the pillar mask cap 22 which are to be self aligned to the first level lead structure are not within the confines of region 23. Etching of the portions of the TiW piller cap mask layer 22 outside the confines of lead photoresist region 23 is performed by a flourine-based plasma etch. Thus, as seen in Figures 6 and 7, the pillar cap mask 22 is reduced to the self aligned pillar cap mask 22A and where desired is made to coincide with the edges of the lead photo resist region 23. Subsequently, additional etching is performed in a Reactive Ion Etch System (R.I.E.) using dry chlorine chemistry into the pillar layer which includes Al-Cu deposit 18 and TiW barrier deposit 16. The photoresist is then stripped to expose Al-Cu deposit 18 except where the pillar pad 22a is located (deposit 18 may then extend from opposite sides of the pillar pad 22a when viewed from the top at this stage of the process). The stripping of the photoresist is done in situ in the R.I.E. system to guard against corrosion of exposed Al-Cu. Pillar pad 22a is thus provided with the dimensions of the lead photoresist region 23.

Once the photoresist is stripped, the R.I.E. system is set up to etch Al-Cu deposits 18 and 14 using the aforesaid chlorine chemistry. The etch uses pillar pad 22a as a mask to etch the pillar interconnection in Al-Cu deposit 18 and the TiW barrier layer 16 to etch the Al-Cu deposit 14 to the dimensions of the first level lead. The etchant selected for removing the Al-Cu deposits 14 and 18 should remove the latter at least 4 times the rate it removes the TiW barrier deposits 22A and 16. A subsequent TiW etch removes pad 22a, and TiW in deposit 12 from the areas around the base of the lower level lead defined by layers 12 and 14 and from level 16 at the base of the pillar interconnection. The resulting device as seen in FIGURES 8 and 9 then receives an anti-corrosion step in situ before being removed for inspection.

As shown in FIGURE 10, a layer of dielectric composed of plasma enhanced CVD oxide 36 to a thickness of about 23 kilo Angstroms is deposited over the first level lead and pillar interconnection. Photoresist 38 is deposited over the plasma oxide 36 with a spin on technique to fill the valleys created by the first level lead and the pillar interconnection and create a planar surface 39 over the whole device.

The planar surface 39 is then etched back in a Reactive Ion Etch System using CHF3 and O2 or other Fluorine chemistries. The etch of the plasma oxide and the ash of photoresist must be near a 1:1 ratio in order to end up with a planar dielectric layer. This can easily be adjusted with flow rates, pressures and power levels. The etch back is stopped, leaving about 1000 A of the top of the pillar interconnection exposed as shown in FIGURE 11.

Finally, as shown in FIGURE 12, a second level lead comprising metal layers 42 and 44 is deposited on planar surface 40 over pillar 18.

The final thickness of the interlevel dielectric is controlled by the height of the pillar and if a thicker dielectric is desired, the process is easily controlled at metal deposition by increasing the Al-Cu thickness.

The pillar interconnection is not limited to the alloys of Al-Cu and TiW, but will work on other two metal systems having differing etch rates.

The process can be repeated for additional levels as desired. Each metal layer is planar and the pillar interconnects between each layer should be ohmic, and not add resistance to the circuit.

The pillar interconnection is defined and etched as the metal lead is being defined and etched, giving it an inherent alignment to the lead. However, it should be understood that this inherent alignment does not encompass "edge-on aligned" as provided by prior techniques. Unlike the via process, the pillar interconnection allows the leads to lay flat on top of the pillar giving no reduction in metal thickness. A pillar between a second and third level of metal can be located directly over a pillar between a first and second level of metal, giving a designer the ability to stack many levels of metal to reduce bar area.

It will thus be seen that the present invention provides a technique for self-aligning a pillar with at least two sides and if desired all sides to the interconnect structure.

Other variations, departures and modifications lying within the spirit of the invention and scope as defined by the appended claims will be obvious to those skilled in the art.

## Claims

1. A method of interconnecting different metal layers through an intermediate insulating layer, comprising the steps of:
forming first and pillar layers of electrically conducting material on the face of a semiconductor;
etching the first layer to form first level leads and the pillar level to form a pillar of conducting material, said pillar and said first level leads being vertically aligned and having equal areas;
depositing a layer of dielectric over said pillar and said first level leads;
etching back the photoresist and dielectric so as to expose a small portion of said pillar;
depositing another layer of conducting material over said pillar and dielectric material to form second level leads.

2. A method according to Claim 1 and further comprising:
applying a layer of photoresist over said dielectric such that the etch rate of said dielectric and photoresist is substantially equal.

3. A method according to Claim 2, wherein said dielectric is plasma oxide sufficiently thick to cover said pillar and first level leads.

4. A method according to Claim 1, wherein said photoresist applying step includes a spin on operation to flatten the photoresist.

5. A method according to Claim 1, wherein first and pillar layers each consist of a lower barrier layer and an upper conductive layer.

6. A method according to Claim 5, including the step of depositing a barrier layer over said pillar layer.

7. A method according to Claim 6, wherein said first level and pillar etching steps include forming etch masks on said barrier layers overlying said first and pillar layers to define etchable areas in the aforesaid.

8. A method of interconnecting different metal layers through an intermediate insulating layer, comprising the steps of:

forming first and pillar layers on the face of a semiconductor each with a bottom deposit of barrier metal alloy and a top deposit of conducting metal alloy and an outer layer of barrier alloy atop said pillar layer;

masking and etching a pillar mask cap area in said outer layer of barrier metal alloy;

masking and etching a pillar pad by etching away portions of said pillar mask cap area;

etching exposed conducting metal alloy deposits in said first and pillar layers defining a pillar interconnection in said pillar layer and a vertically aligned first level lead in said first layer;

depositing a layer of dielectric sufficiently thick to cover said pillar interconnection and said first level lead;

applying a layer of photoresist so as to form a planar surface over said pillar and said first level lead such that the etch rate of said dielectric and photoresist is substantially equal;

etching back the photoresist and dielectric so as to expose a small portion of said pillar; and

depositing another layer of conducting material over said pillar interconnection and dielectric material to form second level leads.

9. A method according to Claim 8, wherein the etching steps include a reactive ion etch.

10. A method according to Claim 8, wherein the dielectric is plasma enhanced CVD oxide.

11. A method according to Claim 8, wherein the barrier metal is tungsten-titanium alloy and the conducting metal is aluminum copper alloy.

12. A semiconductor device comprising:

a region in a face of a semiconductor body;

a first level lead formed by a strip of metal deposited on said body;

a pillar interconnection composed of a metal deposit vertically aligned with at least two sides of said first level lead;

a dielectric having a planar upper surface covering the first level lead and pillar interconnection except for a small portion of the latter; and

a second level lead formed by a strip of metal deposited on said pillar and planar dielectric surface.

13. A semiconductor device according to Claim 12, wherein the semiconductor is silicon and the dielectric is plasma enhanced CVD oxide.

14. A semiconductor device according to Claim 13, wherein the first metal lead and pillar interconnections are each composed of a layer of titanium-tungsten alloy covered by a layer of aluminum-copper alloy.

15. A semiconductor device according to Claim 12 wherein said pillar interconnection is self aligned with the entire perimeter of said first level lead.

16. A method of forming a conductive interconnect on a face of a semiconductor body, comprising the steps of:

applying a first conductive layer to said face, applying a first barrier layer to said face over said first conductive layer, applying a second conductive layer to said face over said first barrier layer, then applying a second barrier layer to said face over said second conductive layer;

selectively removing said second barrier layer to leave a pillar area on said face, then selectively removing said second conductive layer and said first barrier layer to leave a first conductive strip area extending along said face, said conductive strip area being beneath said pillar area at said connector area;

etching said face using said second and first barrier layers as mask to thereby remove said first and second conductive layers except under said pillar to provide a vertically aligned pillar and strip area;

applying an insulator coating to said face to cover the pillar and the conductive strip and to cover other areas of said face not covered by the conductive strip, to produce an uneven surface with raised areas above the pillar and conductive strip;

applying to said face a coating of a filler material which flows to create a plane surface above raised areas and other areas of said face;

etching said face with an etchant which removes said filler material at about the same rate as it removes said insulator coating until the filler material has been removed and the top of the pillar has been exposed, leaving a substantially plane top surface; and

then applying another conductive strip to said face contacting said pillar.

17. A method according to Claim 15, wherein said first and second barrier layers are refractory metal functioning as an etch stop.

18. A method according to Claim 16, wherein said first and second conductive layers are highly conductive metal, and said insulator coating is silicon oxide.

19. A method according to Claim 17, wherein said filler material is photoresist.

20. A method according to Claim 18, wherein said steps of selectively removing the second and first conductive layers use etchant which removes the conductive layers at a rate of at least about four times the rate it removes the barrier layers.

FIG. 1

FIG. 2

FIG. 3

FIG. 4

FIG. 5

FIG. 6

FIG. 7

FIG. 10

FIG. 8

FIG. 11

FIG. 9

FIG. 12

# DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IEEE VLSI MULTILEVEL INTERCONNECTION CONFERENCE, SANTA CLARA, CA, 9th-10th June 1986, pages 450-456, IEEE, New York, US; M.T. WELCH et al.: "Pillar interconnections for VLSI technology" * Whole article * | 1-20 | H 01 L 21/90 H 01 L 21/31 |
| A | IBM TECHNICAL DISCLOSURE BULLETIN, vol. 24, no. 11B, April 1982, pages 5999-6000, New York, US; J.S. LOGAN et al.: "Selective RIE of tiW films" * Whole article * | 9,11,14 ,17,20 | |
| P,X | EP-A-0 285 245 (AT & T) * Page 7, lines 7-41; figure 5 * | 1-3,6,7 ,12,16- 20 | |

|  | | | TECHNICAL FIELDS SEARCHED (Int. Cl.4) |
|---|---|---|---|
|  | | | H 01 L |

The present search report has been drawn up for all claims

| Place of search | Date of completion of the search | Examiner |
|---|---|---|
| THE HAGUE | 17-02-1989 | MACHEK,J. |